# EUROPEAN PATENT APPLICATION

(11) **EP 3 540 335 A1**
(43) Date of publication of application: **18.09.2019**
(21) Application number: 17929627.2
(22) Date of filing: 23.10.2017
(51) Int. Cl.: F25B 21/00

(54) **HEAT DISSIPATION APPARATUS, TERMINAL, AND CONTROL METHOD FOR HEAT DISSIPATION APPARATUS**

(71) Applicant: Guangdong OPPO Mobile Telecommunications Corp., Ltd., Dongguan, Guangdong 523860 (CN)
(72) Inventor: CHEN, Shebiao, Dongguan Guangdong 523860 (CN); ZHANG, Jialiang, Dongguan Guangdong 523860 (CN)
(74) Representative: Hoffmann Eitle
(86) International application number: PCT/CN2017/107387
(87) International publication number: WO 2019/079953

(57) **Abstract**

A heat dissipation device, a terminal, and a method for controlling a heat dissipation device are provided. The heat dissipation device includes a first conductive layer and a second conductive layer disposed opposite to each other, and a power supply control circuit coupled with the first conductive layer and the second conductive layer. The first conductive layer is made of a thermal conductive material. The power supply control circuit is configured to alternately apply, between the first conductive layer and the second conductive layer, a first electric field and a second electric field which are in opposite directions. The above technical scheme is used for dissipating heat for an apparatus through active heat dissipation. With microscopic principle of temperature, the heat dissipation device controls through the power supply control circuit the first conductive layer and the second conductive layer to exchange free electrons with different intensity of thermal motion, thereby achieving thermal conduction and heat dissipation. Unlike conventional active heat dissipation, it is unnecessary to have a complicated system structure in the heat dissipation device, thus reducing the volume of the heat dissipation device.

## Description

### TECHNICAL FIELD

This application relates to the field of heat dissipation, and more particularly to a heat dissipation device and a control method thereof, and a terminal.

### BACKGROUND

Common manners of heat dissipation in an apparatus include active heat dissipation and passive heat dissipation. Under the passive heat dissipation, materials with good thermal conductive property are usually used to transfer heat generated by a heat source to the ambient environment of the apparatus through some components of the apparatus (such as a housing). The passive heat dissipation mainly depends on the performance of a thermal conductive material, since the thermal conduction process of the thermal conductive material is generally very slow, the passive heat dissipation has a low heat dissipation efficiency.

Compared with the passive heat dissipation, the active heat dissipation usually has higher heat dissipation efficiency. Conventional active heat dissipation includes air cooling, water cooling, cooling with an air compressor, and so on. The conventional active heat dissipation requires a heat dissipation device (such as an air cooling system, a water cooling system, an air compressor system, etc.) which has a complicated structure be installed inside the device, which occupies a large space.

### SUMMARY

The present disclosure provides a heat dissipation device, a terminal, and a method for controlling a heat dissipation device, which can reduce the volume of the heat dissipation device.

According to a first aspect, a heat dissipation device is provided. The heat dissipation device includes a first conductive layer and a second conductive layer disposed opposite to each other, and a power supply control circuit coupled with the first conductive layer and the second conductive layer. The first conductive layer is made of a thermal conductive material. The power supply control circuit is configured to alternately apply, between the first conductive layer and the second conductive layer, a first electric field and a second electric field which are in opposite directions.

According to a second aspect, a terminal is provided. The terminal includes a housing and the heat dissipation device described in the first aspect. The heat dissipation device is received in the housing.

According to a third aspect, a method for controlling a heat dissipation device is provided. The heat dissipation device includes a first conductive layer and a second conductive layer disposed opposite to each other, and a power supply control circuit coupled with the first conductive layer and the second conductive layer. The first conductive layer is made of a thermal conductive material. In the method, the power supply control circuit alternately applies, between the first conductive layer and the second conductive layer, a first electric field and a second electric field which are in opposite directions.

The heat dissipation device provided herein is configured to dissipate heat for the apparatus through active heat dissipation. With microscopic principle of temperature, the heat dissipation device controls through the power supply control circuit the first conductive layer and the second conductive layer to exchange free electrons with different intensity of thermal motion, thereby achieving thermal conduction and heat dissipation. Unlike the conventional active heat dissipation, it is unnecessary to introduce a complicated system structure to the heat dissipation device, thus reducing the volume of the heat dissipation device.

### BRIEF DESCRIPTION OF THE DRAWINGS

FIG. 1 is a schematic structural diagram illustrating a heat dissipation device according to an implementation of the present disclosure.
FIG. 2 is a schematic structural diagram illustrating a heat dissipation device according to another implementation of the present disclosure.
FIG. 3 is a schematic diagram illustrating a manner in which a first electric field is applied according to an implementation of the present disclosure.
FIG. 4 is a schematic diagram illustrating a manner in which a second electric field is applied according to an implementation of the present disclosure.
FIG. 5 is a schematic structural diagram illustrating a heat dissipation device according to yet another implementation of the present disclosure.
FIG. 6 is a schematic structural diagram illustrating a terminal according to an implementation of the present disclosure.
FIG. 7 is a schematic flowchart illustrating a method for controlling a heat dissipation device according to an implementation of the present disclosure.

### DETAILED DESCRIPTION

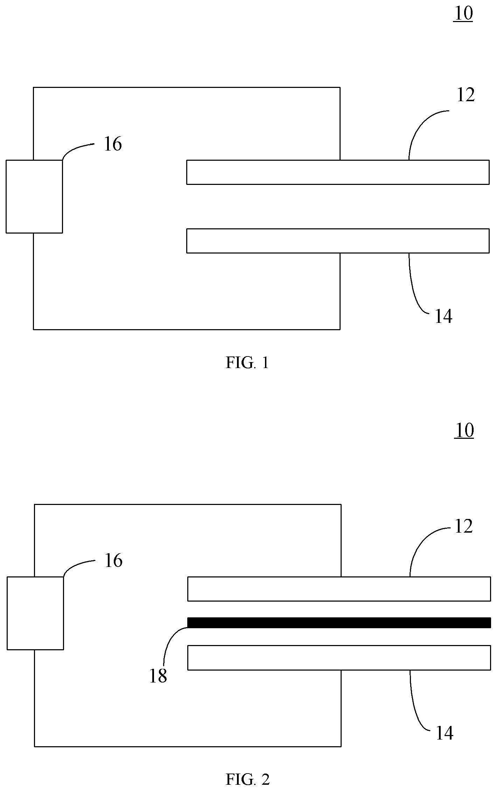

A heat dissipation device with a simple structure and a small volume is provided in the present disclosure. As illustrated in FIG. 1, the heat dissipation device 10 includes a first conductive layer (also known as "electric conductive layer") 12, a second conductive layer 14, and a power supply control circuit 16.

The first conductive layer 12 can be made of a thermal conductive material. In other words, the first conductive layer 12 has not only conductive property but also thermal conductive property. The material of the first conductive layer 12 can be any material with conductive property and thermal conductive property, which is not limited herein. As an example, the first conductive layer 12 is a metal conductive layer. For example, the first conductive layer 12 is a copper conductive layer or an aluminum conductive layer. In practice, the first conductive layer 12 can be placed near a heat source of an apparatus to absorb heat generated by the heat source.

The material of the second conductive layer 14 may be any material having conductive property, which is not limited herein. As an example, the material of the second conductive layer 14 is metal, that is, the second conductive layer 14 is a metal conductive layer. For example, the second conductive layer 14 is a copper conductive layer or an aluminum conductive layer. In addition, in some implementations, the second conductive layer 14 can also be made of a thermal conductive material, that is, the second conductive layer 14 may have both conductive property and thermal conductive property.

The first conductive layer 12 and the second conductive layer 14 are disposed opposite to each other and may form a structure like a capacitor. For example, both the first conductive layer 12 and the second conductive layer 14 may have a plate-like structure, and one side of the first conductive layer 12 is parallel to one side of the second conductive layer 14.

The first conductive layer 12 and the second conductive layer 14 can be set apart from each other, such that an electric field can be created between the first conductive layer 12 and the second conductive layer 14. As an example, the first conductive layer 12 is spaced apart from the second conductive layer 14 via air. As another example, as illustrated in FIG. 2, the first conductive layer 12 is spaced apart from the second conductive layer 14 via an insulating layer 18. The insulating layer 18 can be made of any material with insulation characteristic. For example, the insulating layer 18 is made of polymer (also known as " high-molecular polymer") materials.

The power supply control circuit 16 can be coupled with the first conductive layer 12 and the second conductive layer 14. The power control circuit 16 is configured to alternately apply, between the first conductive layer 12 and the second conductive layer 14, a first electric field and a second electric field which are in opposite directions.

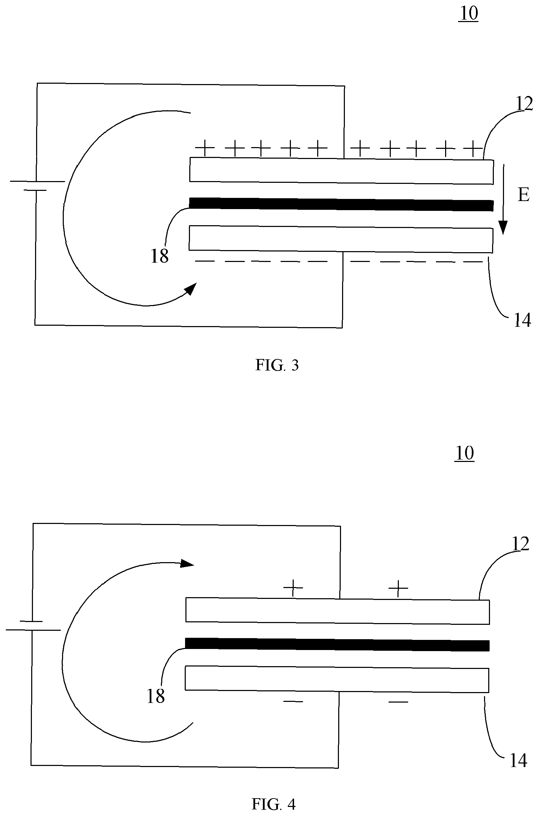

The structure of the power supply control circuit 16 is not limited herein. As an example, the power supply control circuit 16 includes a power supply, a control module, and a switch module. When the first electric field needs be applied between the first conductive layer 12 and the second conductive layer 14, the control module can couple the positive electrode of the power supply with the first conductive layer 12 and couple the negative electrode of the power supply with the second conductive layer 14 through the switch module, thereby forming an equivalent circuit as illustrated in FIG. 3. When the second electric field needs to be applied between the first conductive layer 12 and the second conductive layer 14, the control module can change connection between the power supply and the first conductive layer 12 as well as the second conductive layer 14 through the switch module, such that the negative electrode of the power supply is coupled with the first conductive layer 12 and the positive electrode of the power supply is coupled with the second conductive layer 14, thereby forming an equivalent circuit as illustrated in FIG. 4.

As another example, the power supply control circuit 16 includes a first power supply, a second power supply, and a control module. The positive electrode of the first power supply is coupled with the first conductive layer 12, and the negative electrode of the first power supply is coupled with the second conductive layer 14. The negative electrode of the second power supply is coupled with the first conductive layer 12, and the positive electrode of the second power supply is coupled with the second conductive layer 14. When the first electric field needs to be applied between the first conductive layer 12 and the second conductive layer 14, the control module can control the first power supply to work, thereby forming the equivalent circuit as illustrated in FIG. 3. When the second electric field needs to be applied between the first conductive layer 12 and the second conductive layer 14, the control module can control the second power supply to work, thereby forming the equivalent circuit as illustrated in FIG. 4.

Working of the heat dissipation device 10 will be described below with reference to FIGS. 3 and 4.

First, in a narrow sense, temperature represents the intensity of the thermal motion of molecules.

Assuming that the first conductive layer 12 is near the heat source inside an apparatus, and the second conductive layer 14 is away from the heat source, since the first conductive layer 12 has thermal conductive property, the thermal motion of free electrons inside the first conductive layer 12 is intensified under influence of the heat source.

When the first electric field illustrated in FIG. 3 is applied between the first conductive layer 12 and the second conductive layer 14, under the action of the first electric field, free electrons with intense thermal motion in the first conductive layer 12 are transferred to the second conductive layer 14 via the power supply, and the direction of transfer of the free electrons is illustrated by an arrow in FIG. 3. In contrast, thermal motion of internal molecules of the second conductive layer 14 is slow, and the internal molecules interact (e.g., collide) with the free electrons with intense thermal motion from the first conductive layer 12, which can reduce the intensity of the thermal motion of the free electrons from the first conductive layer 12.

When the second electric field illustrated in FIG. 4 is applied between the first conductive layer 12 and the second conductive layer 14, under the action of the second electric field, free electrons with low thermal motion in the second conductive layer 14 are transferred to the first conductive layer 12 via the power supply, and the direction of transfer of the free electrons is illustrated by an arrow in FIG. 4. Since the thermal motion of the free electrons transferred from the second conductive layer 14 to the first conductive layer 12 is slow, internal molecules of the first conductive layer 12 can interact with the these free electrons transferred from the second conductive layer 14, which can reduce the intensity of the thermal motion of the internal molecules of the first conductive layer 12.

The power supply control circuit 16 alternately applies the first electric field and the second electric field between the first conductive layer 12 and the second conductive layer 14, whereby the free electrons with intense thermal motion in the first conductive layer 12 can be transferred to the second conductive layer 14, and the free electrons with low thermal motion in the second conductive layer 14 can be transferred to the first conductive layer 12. From an overall perspective, the heat of the first conductive layer 12 is transferred to the second conductive layer 14.

The heat dissipation device 10 provided herein is configured to dissipate heat in an apparatus through active heat dissipation. With microscopic principle of temperature, the heat dissipation device 10 controls through the power supply control circuit 16 the first conductive layer 12 and the second conductive layer 14 to exchange free electrons with different intensity of thermal motion, thereby achieving thermal conduction and heat dissipation. Unlike the conventional active heat dissipation, here, it is unnecessary to introduce a complicated system structure to the heat dissipation device 10, thus reducing the volume of the heat dissipation device 10.

The manner of controlling of the power supply control circuit 16 is not limited herein. The following will provide several alternative control manners.

As an example, the power supply control circuit 16 can be configured to perform the following alternately. Apply the first electric field between the first conductive layer 12 and the second conductive layer 14 until an electric field strength of the first electric field reaches a preset first threshold. Apply the second electric field between the first conductive layer 12 and the second conductive layer 14 until an electric field strength of the second electric field reaches a preset second threshold. For example, when the first electric field is applied, the power supply control circuit 16 can monitor the electric field strength between the first conductive layer 12 and the second conductive layer 14. When the electric field strength between the first conductive layer 12 and the second conductive layer 14 reaches the preset first threshold, remove the first electric field, and then apply the second electric filed opposite to the first electric field between the first conductive layer 12 and the second conductive layer 14. When the second electric field is applied, the power supply control circuit 16 can monitor the electric field strength between the first conductive layer 12 and the second conductive layer 14. When the electric field strength between the first conductive layer 12 and the second conductive layer 14 drops to the preset second threshold (the preset second threshold may be greater than or equal to zero), remove the second electric field and then apply the first electric field between the first conductive layer 12 and the second conductive layer 14.

As an example, the power supply control circuit 16 can be configured to perform the following alternately. Apply the first electric field between the first conductive layer 12 and the second conductive layer 14 until a duration of the first electric field reaches a preset first duration. Apply the second electric field between the first conductive layer 12 and the second conductive layer 14 until a duration of the second electric field reaches a preset second duration. For example, when the first electric field is applied, the power supply control circuit 16 can calculate the duration for which the first electric field is applied. When the duration of first electric field reaches the preset first duration, remove the first electric field and then apply the second electric filed opposite to the first electric field between the first conductive layer 12 and the second conductive layer 14. When the second electric field is applied, the power supply control circuit 16 can monitor the duration for which the second electric field is applied. When the duration of the second electric field reaches the preset second duration, remove the second electric field and then apply the first electric field between the first conductive layer 12 and the second conductive layer 14.

A higher frequency of switching between the first electric field and the second electric field results in a higher speed of exchange of free electrons between the first conductive layer 12 and the second conductive layer 14 and a higher efficiency in thermal conduction between the first conductive layer 12 and the second conductive layer 14. The frequency of switching between the first electric field and the second electric field is not limited herein, and may be a fixed frequency or determined according to actual needs.

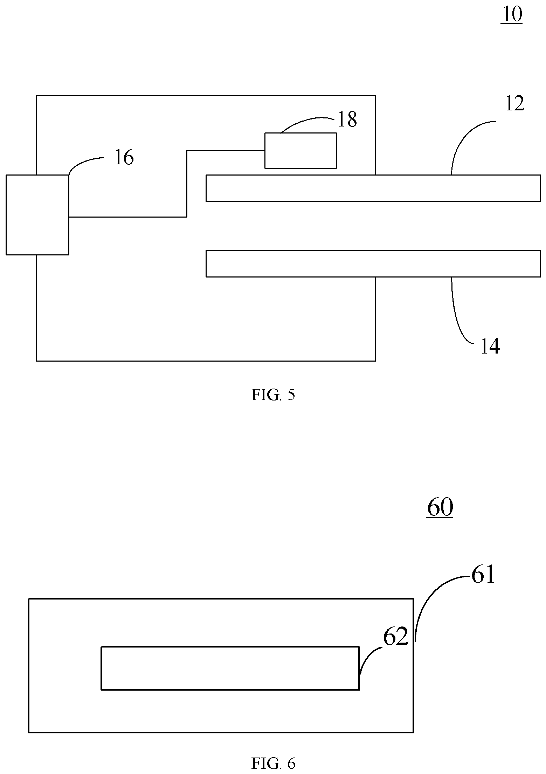

As an example, as illustrated in FIG. 5, the heat dissipation device 10 may further include a temperature measuring device 17. The temperature measuring device 17 can be configured to measure the temperature of the first conductive layer 12. It should be understood that the temperature measuring device 17 can be in contact with the first conductive layer 12 to measure the temperature of the first conductive layer 12. Alternatively, the temperature measuring device 17 can be near the first conductive layer 12, and air temperature around the first conductive layer 12 can be taken as the temperature of the first conductive layer 12. The power supply control circuit 16 can be configured to control the frequency of switching between the first electric field and the second electric field according to the temperature of the first conductive layer 12 measured by the temperature measuring device 17. As an example, the power supply control circuit 16 can control the frequency of switching between the first electric field and the second electric field in a manner that a higher temperature of the first conductive layer 12 leads to a higher frequency of switching between the first electric field and the second electric field. Specifically, the power supply control circuit 16 may record a correspondence relationship between the temperature of the first conductive layer 12 and the frequency of switching in advance, and the frequency of switching between the first electric field and the second electric field is set to the one corresponding to the current temperature of the first conductive layer 12.

According to the implementations of the present disclosure, the frequency of switching between the first electric field and the second electric field is determined according to the temperature of the first conductive layer 12, which improves the intelligence of the heat dissipation device.

A terminal is also provided. As illustrated in FIG. 6, the terminal 60 includes a housing 61 and a heat dissipation device 62 received in the housing 61. The heat dissipation device 62 can be the heat dissipation device 10 described in any of the above implementations.

The terminal mentioned here may be, for example, a mobile terminal such as a "communication terminal" (or "terminal" for short), which can include but is not limited to a device configured via a wired line and/or a wireless interface to receive/transmit communication signals. Examples of the wired line may include, but are not limited to, at least one of a public switched telephone network (PSTN), a digital subscriber line (DSL), a digital cable, a direct connection cable, and/or another data connection line or network connection line. Examples of the wireless interface may include, but are not limited to, a wireless interface with a cellular network, a wireless local area network (WLAN), a digital television network (such as a digital video broadcasting-handheld (DVB-H) network), a satellite network, an amplitude modulation-frequency modulation (AM-FM) broadcast transmitter, and/or with another communication terminal. A communication terminal configured to communicate via a wireless interface may be called a "wireless communication terminal", a "wireless terminal", and/or a "mobile terminal". Examples of a mobile terminal may include, but are not limited to, a satellite or cellular telephone, a personal communication system (PCS) terminal capable of cellular radio telephone, data processing, fax, and/or data communication, a personal digital assistant (PDA) equipped with radio telephone, pager, Internet/Intranet access, web browsing, notebook, calendar, and/or global positioning system (GPS) receiver, and/or other electronic devices equipped with radio telephone capability such as a conventional laptop or a handheld receiver.

The mobile terminal (such as a mobile phone) has small internal space and is difficult to accommodate an active heat dissipation system such as an air cooling system and a water cooling system, and thus a conventional mobile terminal usually adopts passive heat dissipation. In implementations of the present disclosure, the heat dissipation device capable of active heat dissipation is installed inside the mobile terminal, and the heat dissipation device has advantages of small volume and high heat dissipation efficiency and is very suitable for the mobile terminal.

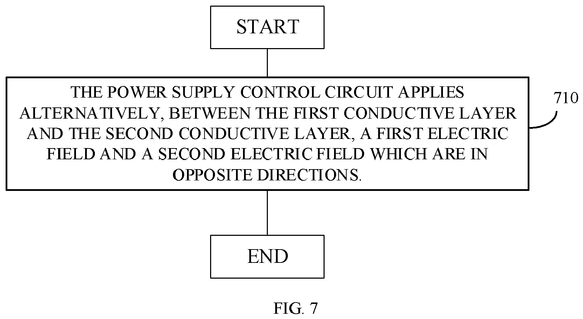

The heat dissipation device and the terminal provided herein are described in detail above with reference to FIGS. 1-6. Hereinafter, a method for controlling a heat dissipation device of implementations of the present disclosure will be described in detail with reference to FIG. 7. The heat dissipation device may be any heat dissipation device 10 described above. For description related to the heat dissipation device, reference can be made to the foregoing description, and repeated description will be properly omitted herein.

The heat dissipation device may include a first conductive layer and a second conductive layer disposed opposite to each other, and a power supply control circuit coupled with the first conductive layer and the second conductive layer. The first conductive layer is made of a thermal conductive material.

The method illustrated in FIG. 7 includes operations at block 710.

At block 710, the power supply control circuit applies, between the first conductive layer and the second conductive layer, a first electric field and a second electric field which are in opposite directions.

In some implementations, operations at block 710 may include the following. The first electric field is applied between the first conductive layer and the second conductive layer until an electric field strength of the first electric field reaches a preset first threshold. The second electric field is applied between the first conductive layer and the second conductive layer until an electric field strength of the second electric field reaches a preset second threshold.

In some implementations, operations at block 710 may include the following. The first electric field is applied between the first conductive layer and the second conductive layer until a duration of the first electric field reaches a preset first duration. The second electric field is applied between the first conductive layer and the second conductive layer until a duration of the second electric field reaches a preset second duration.

In some implementations, the heat dissipation device may further include a temperature measuring device configured to measure the temperature of the first conductive layer 12. The method illustrated in FIG. 7 further includes that the power supply control circuit controls a frequency of switching between the first electric field and the second electric field according to the temperature of the first conductive layer measured by the temperature measuring device.

The above-mentioned implementations may be implemented, in whole or in part, in software, hardware, firmware, or any other combination thereof. When implemented in software, the implementations may be implemented, in whole or in part, in the form of a computer program product. The computer program product includes one or more computer instructions. When the computer program instructions are loaded and executed on a computer, procedures or functions described herein are generated in whole or in part. The computer can be a general-purpose computer, a special-purpose computer, a computer network, or other programmable devices. The computer instructions may be stored in a computer readable storage medium, or transmitted from one computer readable storage medium to another computer readable storage medium. For example, the computer instructions may be transmitted from one website, computer, server, or data center to another website site, computer, server, or data center in a wired manner or a wireless manner. Examples of the wired manner may include, but are not limited to a coaxial cable, an optical fiber, and a digital subscriber line (DSL). Examples of the wireless manner may include, but are not limited to infrared transmission, wireless transmission, and microwave transmission. The computer readable storage medium can be any usable medium that is accessible to the computer or a data storage device such as a server, data center, or other one or more usable media integrated devices. The usable medium may be a magnetic medium (for example, a floppy disk, a hard disk, a magnetic tape), an optical medium (such as a digital video disc (DVD)), or a semiconductor medium (such as a solid state disk (SSD)).

Those of ordinary skill in the art will appreciate that, exemplary units and algorithm steps described in connection with the implementations disclosed herein can be implemented in electronic hardware, or in a combination of computer software and electronic hardware. Whether these functions are implemented in hardware or software depends on the specific application and design constraints of the technical solution. A professional technician could use different methods to implement the functions described herein for each particular application, but such implementations should not be considered to be beyond the scope of the present disclosure.

It will be appreciated that the systems, devices, and methods disclosed in several implementations according to the present application may also be implemented in various other manners. For example, the above device implementations are merely illustrative, e.g., the division of units is only a division of logical functions, and there may exist other ways of division in practice, e.g., multiple units or components may be combined or may be integrated into another system, or some features may be ignored or not included. In other respects, the coupling or direct coupling or communication connection as illustrated or discussed may be an indirect coupling or communication connection through some interface, device or unit, and may be electrical, mechanical, or otherwise.

Separated units as illustrated may or may not be physically separated. Components or parts displayed as units may or may not be physical units, and may reside at one location or may be distributed to multiple networked units. Some or all of the units may be selectively adopted according to practical needs to achieve desired objectives of the disclosure.

Additionally, various functional units described in various implementations according to the present disclosure herein may be integrated into one processing unit or may be present as a number of physically separated units, and two or more units may be integrated into one.

The above is only implementations of the present disclosure, and the scope of protection of the present disclosure is not limited thereto. Changes or substitutions that can be easily made by those skilled in the art without departing from the scope of the present disclosure shall be covered by the scope of protection of the present disclosure. The scope of protection of the disclosure shall be subject to the scope of protection of the appended claims.

## Claims

1. A heat dissipation device, comprising:
a first conductive layer and a second conductive layer disposed opposite to each other, and the first conductive layer being made of a thermal conductive material; and
a power supply control circuit, coupled with the first conductive layer and the second conductive layer and configured to alternately apply, between the first conductive layer and the second conductive layer, a first electric field and a second electric field which are in opposite directions.

2. The heat dissipation device of claim 1, further comprising:
an insulating layer, disposed between the first conductive layer and the second conductive layer.

3. The heat dissipation device of claim 2, wherein the insulating layer is made of a polymer material.

4. The heat dissipation device of any of claims 1 to 3, wherein the power supply control circuit is configured to alternately:
apply the first electric field between the first conductive layer and the second conductive layer until an electric field strength of the first electric field reaches a preset first threshold; and
apply the second electric field between the first conductive layer and the second conductive layer until an electric field strength of the second electric field reaches a preset second threshold.

5. The heat dissipation device of any of claims 1 to 3, wherein the power supply control circuit is configured to alternately:
apply the first electric field between the first conductive layer and the second conductive layer until a duration of the first electric field reaches a preset first duration; and
apply the second electric field between the first conductive layer and the second conductive layer until a duration of the second electric field reaches a preset second duration.

6. The heat dissipation device of any of claims 1 to 5, further comprising:
a temperature measuring device, configured to measure a temperature of the first conductive layer; and
the power supply control circuit being further configured to control a frequency of switching between the first electric field and the second electric field according to the temperature of the first conductive layer measured by the temperature measuring device.

7. The heat dissipation device of any of claims 1 to 6, wherein at least one of the first conductive layer and the second conductive layer is a metal conductive layer.

8. A terminal, comprising:
a housing; and
the heat dissipation device of any of claims 1 to 7, the heat dissipation device being received in the housing.

9. The terminal of claim 8, wherein the terminal is a mobile terminal.

10. A method for controlling a heat dissipation device, the heat dissipation device comprising:
a first conductive layer and a second conductive layer disposed opposite to each other, and the first conductive layer being made of a thermal conductive material; and
a power supply control circuit, coupled with the first conductive layer and the second conductive layer;
the method comprising:
applying alternately, by the power supply control circuit, a first electric field and a second electric field which are in opposite directions, between the first conductive layer and the second conductive layer.

11. The method of claim 10, wherein applying alternately the first electric field and the second electric field which are in opposite directions between the first conductive layer and the second conductive layer comprises:
applying the first electric field between the first conductive layer and the second conductive layer until an electric field strength of the first electric field reaches a preset first threshold; and
applying the second electric field between the first conductive layer and the second conductive layer until an electric field strength of the second electric field reaches a preset second threshold.

12. The method of claim 10, wherein applying alternately the first electric field and the second electric field which are in opposite directions between the first conductive layer and the second conductive layer comprises:
applying the first electric field between the first conductive layer and the second conductive layer until a duration of the first electric field reaches a preset first duration; and
applying the second electric field between the first conductive layer and the second conductive layer until a duration of the second electric field reaches a preset second duration.

13. The method of any of claims 10 to 12, wherein the heat dissipation device further comprises a temperature measuring device configured to measure a temperature of the first conductive layer;
the method further comprising:
controlling, by the power supply control circuit, a frequency of switching between the first electric field and the second electric field according to the temperature of the first conductive layer measured by the temperature measuring device.
